(19) **Europäisches Patentamt**
**European Patent Office**
**Office européen des brevets**

(11) **EP 2 570 510 B2**

(12) **NEW EUROPEAN PATENT SPECIFICATION**
After opposition procedure

(45) Date of publication and mention
of the opposition decision:
**13.02.2019 Bulletin 2019/07**

(45) Mention of the grant of the patent:
**30.03.2016 Bulletin 2016/13**

(21) Application number: **11181640.1**

(22) Date of filing: **16.09.2011**

(51) Int Cl.:
**C23C 16/40** *(2006.01)*   **C23C 16/52** *(2006.01)*
**C23C 30/00** *(2006.01)*

(54) **Sulfur containing alpha-alumina coated cutting tool**

Schwefelhaltiges alpha-aluminbeschichtetes Schneidwerkzeug

Outil de découpe revêtu d'alpha-alumine contenant du soufre

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**20.03.2013 Bulletin 2013/12**

(73) Proprietor: **Walter AG**
**72072 Tübingen (DE)**

(72) Inventors:
• **Stiens, Dirk**
**72762 Reutlingen (DE)**
• **Ruppi, Sakari**
**72070 Tübingen (DE)**

(74) Representative: **WSL Patentanwälte Partnerschaft
mbB**
**Kaiser-Friedrich-Ring 98**
**65185 Wiesbaden (DE)**

(56) References cited:
| | |
|---|---|
| EP-A1- 0 045 291 | EP-A1- 0 693 574 |
| EP-A1- 1 655 392 | EP-A1- 1 953 269 |
| EP-A2- 1 479 791 | EP-A2- 1 609 883 |
| EP-A2- 1 616 977 | WO-A1-97/47785 |
| JP-A- 2000 218 410 | JP-A- 2003 025 114 |
| JP-A- 2005 264 194 | JP-A- 2007 185 751 |
| JP-A- 2008 093 769 | US-A- 5 786 069 |

US-A1- 2004 028 951   US-B2- 7 094 447
US-E- R E41 972

• <<<NON-CITED DOCUMENT>>> M'SAOUBI R. et al.: "Wear and thermal behavior of CVD alpha-Al2O3 and MTCVD Ti(C,N) coatings during machining''.", CIRP Annals - Manufacturing Technology, vol. 58, no. 1, 2009, pages 57-60, XP026120209,
• <<<NON-CITED DOCUMENT>>> SHIRAI T. et al: "Structural Properties and Surface Characteristics on Aluminum Oxide Powders.", Annual report of the Ceramics Research Laboratory, vol. 9, 2009, pages 23-31, XP055323284,
• <<<NON-CITED DOCUMENT>>> WILHARTITZ P. et al: "Distribution analysis of carbon and sulphur in CVD-Al2O3-layers by SIMS using Cs+ primary ions", Surface and Interface Analysis, vol. 8, 1986, pages 159-165, XP055339379,
• <<<NON-CITED DOCUMENT>>> SCOTT D.: "9th Plansee Seminar", TRIBOLOGY International, August 1977 (1977-08), pages 247-248, XP055339384,
• <<<NON-CITED DOCUMENT>>> NIST SP 260-176. anuary 2013. NIST Standard Reference Materials Technical Catalog. (cover page, bibliographic information. Table of contents and pages 129-134)
• <<<NON-CITED DOCUMENT>>> Klaus Peter Jochum et al: "Determination of Reference Values for NIST SRM 610 617 Glasses Following ISO Guidelines", Geostandards and Geoanalytical Research, vol. 35, no. 4, 11 June 2011 (2011-06-11), pages 397-429, DOI: doi.org/10.1111/j.1751-908X.2011.00120.x |

EP 2 570 510 B2

**(Cont. next page)**

- <<<NON-CITED DOCUMENT>>> Smith D.K.: "DB2dl: Extracting Peak Height d-I Data for the Powder Diffraction File from Rietveld Analyses", Advances in X-ray Analysis, vol. 42, 2000, pages 223-227,

- <<<NON-CITED DOCUMENT>>> Declaration by MR. Lee

**Description**

FIELD OF THE INVENTION

The present invention relates to a cutting tool insert consisting of a substrate of cemented carbide, cermet, ceramics, steel or a superhard material such as cubic boron nitride (CBN) and a hard coating consisting of one or more refractory layers of which at least one layer is an $\alpha$-$Al_2O_3$ layer containing sulphur and having a specified growth orientation defined by the texture coefficient, and a method of manufacturing the cutting tool insert.

BACKGROUND OF THE INVENTION

The early approaches to deposit $Al_2O_3$ on a substrate surface in a CVD process based on a $AlCl_3/CO_2/H_2$ reaction gas mixture had a very low deposition rates in the order of about 0.2 $\mu$m/h on flat surfaces. Besides the fact that it was not possible to control the phase content, this early $Al_2O_3$ deposition process also suffered from a pronounced dog-bone-effect, i.e. the deposition rate was higher on the edges than on the flat surfaces of the substrate. US 4,619,866 by Smith and Lindstom discloses that dopants, such as $H_2S$, could be used as a catalyst both to enhance the overall deposition rate but also to suppress the dog-bone effect. With the introduction of $H_2S$ as a catalyst for the $\alpha$-$Al_2O_3$ deposition process the deposition rate increased by a factor of about five coinciding with a more or less complete elimination of the dog-bone effect as compared to the process without any $H_2S$ present

Several attempts have been made to deposit industrial alpha and gamma alumina coatings onto cutting tools by CVD or PVD using sulphur containing dopants. In EP-A-0 045 291 the addition of 0.02-0.3 vol-% of sulphur, selenium or tellurium containing gas, preferably $H_2S$, to the deposition gas in the CVD process has been found to increase the growth rate and to improve the uniformity of alumina coatings. EP-A-1 788 124 describes the deposition of alpha alumina coatings having a defined crystal grain boundary orientation wherein the deposition of the alumina is performed by CVD adding from 0.25-0.6 vol-% of $H_2S$ to the deposition gas. EP-A-1 683 893 describes the deposition of alpha alumina coatings having a defined amount of $\Sigma3$ type grain boundary length wherein the deposition of the alumina is performed by CVD adding from 1.5-5 vol-% HCl and from 0.05-0.2 vol-% of $H_2S$ to the deposition gas. The prior art literature does not describe the actual sulphur content in the alpha alumina coatings. Since $H_2S$ has only been used to enhance the growth rate and prevent the dog-bone effect, there have been no attempts to use higher amounts of sulfur-containing dopants or consider the sulfur content in the $\alpha$-$Al_2O_3$ coatings in general. One reason for this is that, as diclosed in US-A-4,619,866, the effect of $H_2S$ on the growth rate on alumina was found to be at maximum at a $H_2S$ concentration of 0.25 to 0.3 vol%. Larger amounts of $H_2S$ than about 0.3 vol% were found to result in strongly reduced growth rates"

OBJECT OF THE INVENTION

It is an object of the present invention is to provide a coated cutting tool having an $\alpha$-$Al_2O_3$ layer that exhibits improved cutting properties, improved chipping resistance and improved crater wear resistance as well as lower friction in contact with the workpiece over the prior-art.

DESCRIPTION OF THE INVENTION

The present invention relates to a cutting tool insert consisting of a substrate of cemented carbide, cermet, ceramics, steel or a superhard material such as cubic boron nitride (CBN) and a coating with a total thickness of 5 to 40 $\mu$m, the coating consisting of one or more refractory layers of which at least one layer is an $\alpha$-$Al_2O_3$ layer having a thickness of 1 to 25 $\mu$m, wherein the at least one $\alpha$-$Al_2O_3$ layer having a sulphur content of more than 100 ppm analysed by Secondary Ion Mass Spectroscopy (SIMS) and
the at least one $\alpha$-$Al_2O_3$ layer having a texture coefficient TC (0 0 12) > 4 for the (0 0 12) growth direction, the TC (0 0 12) being defined as follows:

$$TC(0\,0\,12) = \frac{I(0\,0\,12)}{I_0(0\,0\,12)} \left[ \frac{1}{n} \sum_{n-1}^{n} \frac{I(hkl)}{I_0(hkl)} \right]^{-1}$$

(hkl) = measured intensity of the (hkl) reflection
$I_0$ (hkl) = standard intensity of the standard powder diffraction data according to JCPDF-card no. 42-1468
n = number of reflections used in the calculation, whereby the (hkl) reflections used are: (012), (104), (110), (113), (116), (300) and (0 0 12).

**EP 2 570 510 B2**

It has surprisingly been found that improved cutting properties, improved chipping resistance and improved crater wear resistance of the cutting tool insert as well as lower friction in contact with the workpiece can be achieved if the $\alpha$-Al$_2$O$_3$ layer has a high sulphur content of more than 100 ppm analysed by Secondary Ion Mass Spectroscopy (SIMS) and a texture coefficient TC (0 0 12) > 4 for the (0 0 12) growth direction.

In a preferred embodiment of the present invention the at least one $\alpha$-Al$_2$O$_3$ layer of the cutting tool insert has a sulphur content of more than 120 ppm, preferably more than 150 ppm analysed by SIMS. It has been found that the cutting properties of the inventive cutting tool can be further improved by a higher sulphur content.

However, the sulphur content of the $\alpha$-Al$_2$O$_3$ layer should not exceed 2000 ppm, since a larger sulphur content may impair the properties of the cutting tool, such as grain boundary strength, and, in addition, cause porosity.

In another preferred embodiment of the cutting tool insert of the present invention the coating comprises, in addition to the at least one $\alpha$-Al$_2$O$_3$ layer, one or more refractory layers consisting of carbide, nitride, carbonitride, oxycarbonitride or borocarbonitride of one or more of Ti, Zr, V and Hf, or combinations thereof deposited using CVD or MT-CVD, having a thickness of from 0.5 to 20 $\mu$m, preferably from 1 to 10 $\mu$m.

Preferably, the coating comprises a first layer adjacent to the substrate body of CVD deposited Ti(C,N), TiN, TiC or HfN, or MT-CVD deposited Ti(C,N), Zr(C,N), Ti(B,C,N), or combinations thereof. Most preferably, the first layer is if Ti(C,N).

In yet another preferred embodiment of the cutting tool insert of the present invention

    a) the uppermost layer of the coating is the $\alpha$-Al$_2$O$_3$ layer or

    b) the uppermost layer of the coating is a layer of carbide, nitride, carbonitride or oxycarbnitride of one or more of Ti, Zr, V and Hf, or combinations thereof (herein called Ti top coating), having a thickness of from 0.5 to 3 $\mu$m, preferably 0.5 to 1.5 $\mu$m, being deposited atop of the $\alpha$-Al$_2$O$_3$ layer or

    c) surface areas of the cutting tool insert, preferably the rake face of the cutting tool insert, comprise the $\alpha$-Al$_2$O$_3$ layer a) as the uppermost layer whereas the remaining surface areas of the cutting tool insert comprise as the uppermost layer a layer b) of carbide, nitride, carbonitride or oxycarbnitride of one or more of Ti, Zr, V and Hf, or combinations thereof, having a thickness of from 0.5 to 3 $\mu$m, preferably 0.5 to 1.5 $\mu$m, being deposited atop of the $\alpha$-Al$_2$O$_3$ layer.

The Ti top coating layer atop the $\alpha$-Al$_2$O$_3$ layer can be provided as a wear indicator or as a layer of other functions. Embodiments, where only parts of the surface areas of the cutting tool insert, preferably the rake face of the cutting tool insert, comprise the $\alpha$-Al$_2$O$_3$ layer as the uppermost layer whereas the remaining surface areas are covered with the Ti top coating as the outermost layer, can be produced by removing the deposited Ti top coating by way of blasting or any other well known method.

In another preferred embodiment of the cutting tool insert of the present invention the substrate consists of cemented carbide, preferably of cemented carbide consisting of 4 to 12 wt-% Co, optionally 0.3-10 wt-% cubic carbides of the metals from groups IVb, Vb and VIb of the periodic table, preferably Ti, Nb, Ta or combinations thereof, and balance WC.

For steel machining applications the cemented carbide substrate preferably contains 7.0 to 9,0 wt-% cubic carbides of the metals from groups IVb, Vb and VIb of the periodic table, preferably Ti, Nb and Ta, and for cast iron machining applications the cemented carbide substrate preferably contains 0.3 to 3,0 wt-% cubic carbides of the metals from groups IVb, Vb and VIb of the periodic table, preferably Ti, Nb and Ta.

In another preferred embodiment of the cutting tool insert of the present invention the substrate consists of cemented carbide comprising a binder phase enriched surface zone having a thickness of 5 to 30 $\mu$m, preferably 10 to 25 $\mu$m, from the substrate surface, the binder phase enriched surface zone having a Co content that is at least 1.5 times higher than in the core of the substrate and having a content of cubic carbides that is less than 0.5 times the content of cubic carbides in the core of the substrate. The thickness of the $\alpha$-Al$_2$O$_3$ layer in this embodiment is preferably about 4 to 12 $\mu$m, most preferably 4 to 8 $\mu$m.

Preferably, the binder phase enriched surface zone of the cemented carbide body is essentially free from cubic carbides. The binder enriched surface zone enhances toughness of the substrate and widens the application range of the tool. Subtrates having a binder enriched surface zone are particularly preferred for cutting tool inserts for metal cutting operations in steel, whereas cutting tool inserts for metal cutting operations in cast iron are preferably produced without binder enriched surface zone.

In another preferred embodiment of the cutting tool insert of the present invention the at least one $\alpha$-Al$_2$O$_3$ layer has a texture coefficient TC (0 0 12) > 5, more preferably a texture coefficient TC (0 0 12) > 6 for the (0 0 12) growth direction.

The present invention further provides a method of manufacturing a cutting tool insert as defined herein wherein said at least one $\alpha$-Al$_2$O$_3$ layer is deposited by chemical vapour deposition (CVD) the reaction gas of the CVD process comprising H$_2$, CO$_2$, AlCl$_3$, HCl and X with X being H$_2$S, SO$_2$, SF$_6$, or combinations thereof, and optional additions of N$_2$ and Ar, wherein the X is present in the reaction gas mixture in an amount of at least 1.2 vol-% of the total volume of gases in the CVD reaction chamber and wherein the volume ratio of $CO_2$ and X in the CVD reaction chamber lies within the range of $1 \leq CO_2/X \leq 7$ during deposition of the at least one $\alpha\text{-Al}_2O_3$ layer and the volume ratio of $AlCl_3/HCl$ in the CVD reaction chamber is equal or smaller than 1 during deposition of the at least one alpha-$Al_2O_3$ layer.

It has surprisingly been found that the inventive $\alpha\text{-Al}_2O_3$ coating can be controlled by particular deposition conditions. The inventive kind of high sulphur content and the texture coefficient TC(0 0 12) >4 of the $\alpha\text{-Al}_2O_3$ coating can be achieved by the control of the volume portion of the sulfur containing dopant X in the reaction gas mixture of the total volume of gases in the CVD reaction chamber in an amount of at least 1.2 vol%, and, at the same time, by control of the volume ratio of $CO_2$ and X in the CVD deposition reaction. Cutting tests and friction tests have clearly confirmed the beneficial effects of high sulfur content in the $\alpha\text{-Al}_2O_3$ layer.

If the amount X is less than 1.2 vol-% of the total volume of gases in the CVD reaction chamber the sulphur content that can be achieved in the $\alpha\text{-Al}_2O_3$ coating will not be sufficiently high.

It has been found that the introduction of a high amount of sulphur containing dopant X alone will not lead to a high sulphur content in the coating. The inventors have found that the ratio of sulfur containing dopant X to $CO_2$ during CVD strongly affects the sulfur content in the deposited $\alpha\text{-Al}_2O_3$ layer. Studies by the inventors have confirmed that deposition of $\alpha\text{-Al}_2O_3$ with a high sulfur content is difficult if too high $CO_2/X$ ratios during deposition are used. It was surprising that the control of the $CO_2/X$ ratio in the CVD deposition process of $\alpha\text{-Al}_2O_3$ is the most important factor to obtain a high sulfur content in the $\alpha\text{-Al}_2O_3$ layer and, surprisingly and most importantly, that certain ratios resulted exclusively in high amounts of sulfur with good reproducibly. Thus, the present invention provides for a new a method to control the sulfur content of $\alpha\text{-Al}_2O_3$ deposited by CVD.

In a preferred embodiment of the method of the present invention the volume proportion of the component X or the combination of components X is present in the reaction gas mixture during deposition of the at least one $\alpha\text{-Al}_2O_3$ layer in an amount of at least 1.5 vol-% of the total volume of gases in the CVD reaction chamber. In another embodiment the volume proportion of the component X or the combination of components X lies within the range of 2.0 to 3.0 vol-%.

It has surprisingly been found that the sulphur content and the texture coefficient TC(0 0 12) of the $\alpha\text{-Al}_2O_3$ layer can be further improved by higher X content in the reaction gas mixture during deposition of the $\alpha\text{-Al}_2O_3$ layer resulting in improved cutting properties, improved chipping resistance and improved crater wear resistance of the cutting tool insert. However, a too high content of X, for example above 5.0 vol-%, should be avoided due to the danger of handling the sulphur sources. For example, the preferred sulphur source, $H_2S$, is a flammable and extremely hazardous gas.

In another preferred embodiment of the method of the present invention the volume ratio of $CO_2$ and X in the CVD reaction chamber lies within the range of $1 \leq CO_2/X \leq 6$ during deposition of the at least one $\alpha\text{-Al}_2O_3$ layer.

In yet another preferred embodiment of the method of the present invention the volume ratio of $CO_2/AlCl_3$ in the CVD reaction chamber is equal or smaller than 1.5 during deposition of the at least one $\alpha\text{-Al}_2O_3$ layer.

The CVD process of the present invention during deposition of the at least one $\alpha\text{-Al}_2O_3$ layer is suitably conducted at a temperature in the range of 850 to 1050 °C, preferably 980 to 1050 °C, most preferably 1000 to 1020 °C. If the temperature of the CVD process is too low, the growth rate would be too low, and f the temperature of the CVD process is too high, gas-phase nucleation and non-uniform growth will occur.

The reaction gas pressure range where the CVD process of the present invention is conducted during deposition of the at least one $\alpha\text{-Al}_2O_3$ layer is preferably from 50 to 120 mbar, more preferably from 50 to 100 mbar.

In yet another preferred embodiment of the method of the present invention the component X in the CVD process is $H_2S$ or $SO_2$ or a combination of $H_2S$ and $SO_2$, whereby, if the component X in the CVD process is a combination of $H_2S$ and $SO_2$, the volume proportion of $SO_2$ does not exceed 20% of the volume amount of $H_2S$. If too much $SO_2$ is used the coating uniformity can be reduced due to the so-called dog-bone effect.

In yet another preferred embodiment of the method of the present invention the reaction gas of the CVD process comprises additions of $N_2$ and/or Ar in a volume amount in the range of 4 to 20 vol%, preferably 10-15 vol%, of the total volume of gases in the CVD reaction chamber.

As will be shown in the examples below, the coatings of the invention exhibit an excellent chipping resistance in a high-speed intermittent cutting and enhanced crater wear resistance in continuous turning over the prior-art coatings.

METHODS

Secondary Ion Mass Spectroscopy (SIMS)

The measurement of sulphur in the alumina coatings has been done by Secondary Ion Mass Spectroscopy (SIMS) on a Cameca ims3f spectrometer. The quantitative determination of the sulphur concentration in a sample was done relative to the known aluminum concentration in the sample. For the determination of the sensitivity (relative ion yield) for sulphur relative to aluminum the reference glas SRM 610 of the *National Institute of Standards and Technology (NIST)* was used. The sulphur concentration in SRM 610 is 575 ug/g, and the relative accuracy of the measurements is about ± 20%.

The sample surface was sputtered with negative oxygen ions having an energy of 14.5 keV. The primary ion current was about 30 nA, and the diameter of the focussed primary ion beam at the sample surface was about 30-40 $\mu$m. The generated positive secondary ions were accelerated to an energy of 4.5 keV and measured with a mass spectrometer at a mass resolution of $m/\Delta m$=1800 using a secondary ion multiplier in counting modus (for $^{32}$S) and with a Faraday cup (for $^{27}$Al), respectively. The starting energy of the detected secondary ions was 55 ± 20 eV to lower molecular interferences and increase the measurement accuracy (energy filtering). As the measurement results the average of six equal measurement cycles was calculated. The integration times per cycle were 25 sec for $^{32}$S and 3 sec for $^{27}$Al, respectively. For each sample the measurements have been repeated 5 times.

EXAMPLES

Example 1 - $\alpha$-Al$_2$O$_3$ coatings

Cemented carbide substrates for cutting inserts with a composition of 6.0 wt% Co and balance WC (hardness about 1600 HV) were coated with a Ti(C,N) layer by applying MT-CVD using 0.6 vol% CH$_3$CN, 3.8 vol% TiCl$_4$, 20 vol% N$_2$ and balance H$_2$. The thickness of the Ti(C,N) MT-CVD layer was about 5$\mu$m.

Onto this Ti(C,N) layer of separate substrate samples different layers consisting of about 8 $\mu$m $\alpha$-Al$_2$O$_3$ were deposited. The coating parameters are given in Table 1, and the texture coefficients, TC(0 0 12), measured by X-ray diffraction, and the sulphur concentrations in the $\alpha$-Al$_2$O$_3$ coatings, measured by SIMS, are given in Table 2.

The deposition of $\alpha$-Al$_2$O$_3$ was started by depositing a 0.05 $\mu$m to about 1 $\mu$m thick bonding layer on top of the MTCVD layer from the system H$_2$-N$_2$-CO-TiCl$_4$-AlCl$_3$ at a pressure of 50 to 100 mbar. $\alpha$-Al$_2$O$_3$ was nucleated on the (Ti,Al)(C,N,O) bonding layer by treating said layer with a gas mixture of 0.7 to 2.5 vol% CO$_2$, >95 vol% H$_2$ for 2 to 60 min at a temperature from about 750 to 1050 °C, preferably at about 980 to 1020 °C and most preferably at 1000 to 1020 °C (P= 80 to 100 mbar). The alumina deposition was started with a sequence without precursor X for about 10 min. All the precursors, except HCl, were shunted into the reactor simultaneously 2 min after HCl introduction.

Table 1 - $\alpha$-Al$_2$O$_3$ coatings

| Coating | H$_2$S [vol%] | SO$_2$ [vol%] | CO$_2$ [vol%] | AlCl$_3$ [vol%] | Ar$_2$ [vol%] | N$_2$ [vol%] | HCl [vol%] | H$_2$ [vol%] | pressure [mbar] | CO$_2$/X ratio |
|---|---|---|---|---|---|---|---|---|---|---|
| 1a | 0.5 | --- | 5.0 | 3.4 | 5.0 | 10.0 | 3.4 | bal. | 80 | 10 |
| 1b | 0.5 | --- | 2.5 | 3.2 | 5.0 | 10.0 | 3.3 | bal. | 80 | 5 |
| 2a | 1.0 | --- | 8.0 | 5.4 | 5.0 | 10.0 | 5.4 | bal. | 80 | 8 |
| 2b | 1.0 | --- | 4.0 | 2.7 | 5.0 | 10.0 | 2.7 | bal. | 80 | 4 |
| 3a | 1.8 | --- | 14.4 | 9.6 | 5.0 | 10.0 | 9.6 | bal. | 80 | 8 |
| 3b X | 1.8 | --- | 9.0 | 6.0 | 5.0 | 10.0 | 6.0 | bal. | 80 | 5 |
| 3c X | 1.8 | --- | 3.6 | 2.4 | 5.0 | 10.0 | 2.4 | bal. | 80 | 2 |
| 4a | 2.4 | --- | 21.6 | 14.4 | 5.0 | 10.0 | 14.4 | bal. | 80 | 9 |
| 4b X | 2.4 | --- | 2.4 | 1.6 | 5.0 | 10.0 | 1.6 | bal. | 80 | 1 |
| 5 | 0.4 | 0.1 | 4.0 | 2.7 | 5.0 | 10.0 | 2.7 | bal. | 80 | 8 |
| 6 | 0.9 | 0.1 | 16.0 | 10.5 | 5.0 | 10.0 | 11.0 | bal. | 80 | 16 |
| 7 | 0.9 | 0.1 | 4.0 | 4.7 | 5.0 | 10.0 | 7.2 | bal. | 80 | 4 |
| 8 | 1.5 | 0.3 | 15.0 | 10.0 | 5.0 | 10.0 | 12.0 | bal. | 80 | 8.3 |
| 9X | 1.5 | 0.3 | 7.5 | 5.0 | 5.0 | 10.0 | 5.0 | bal. | 80 | 4.2 |
| 10 X | 1.5 | 0.3 | 2.0 | 1.4 | 5.0 | 10.0 | 1.4 | bal. | 80 | 1.1 |
| 11 | 2.0 | 0.4 | 20.0 | 2.0 | 5.0 | 10.0 | 2.0 | bal. | 80 | 8.4 |
| 12 X | 2.0 | 0.4 | 3.0 | 2.0 | 5.0 | 10.0 | 2.0 | bal. | 80 | 1.3 |
| X = invention | | | | | | | | | | |

Table 2 - α-Al$_2$O$_3$ coatings

| Coating | TC(0 0 12) | Sulphur [ppm] |
|---|---|---|
| 1a | --- | 15 |
| 1b | 2.2 | 30 |
| 2a | 2.6 | 40 |
| 2b | 4.8 | 101 |
| 3a | 3.8 | 60 |
| 3b X | 4.1 | 108 |
| 3c X | 5.9 | 220 |
| 4a | 3.2 | 80 |
| 4b X | 6.8 | 390 |
| 5 | 4.2 | 51 |
| 6 | 0.8 | 32 |
| 7 | 5.7 | 102 |
| 8 | 3.8 | 40 |
| 9 X | 6.1 | 119 |
| 10 X | 6.7 | 222 |
| 11 | 2.3 | 72 |
| 12 X | 6.9 | 385 |
| X = invention | | |

The inserts with coatings 4a and 4b were tested for friction coefficient using the pin-on-disc method. The coating 4a showed a friction coefficient of 0.56, whereas the coatings 4b and 12 showed a lower friction coefficient of 0.42 and 0.39, respectively. Thus, a high sulphur content in the alpha alumina coatings has been identified to be friction reducing.

Example 2 - Edge Toughness Tests

The samples 1a to 4b of Example 1 were tested with respect to edge toughness (chipping resistance) in longitudinal turning of cast iron (GG25) using the following cutting parameters:

Work piece: GG25; cylindrical bar
Insert type: SNUN
Cutting speed: $v_c$=400 m/min
Feed (f) = 0,4 mm/rev
Depth of cut: $a_p$=2,0 mm
Remarks: dry turning

The inserts were inspected after 2 and 4 minutes of cutting. As shown in Table 3, compared to the coating of the prior art, the edge toughness of the samples was considerably enhanced when the coating was produced according to this invention.

Table 3 - Edge Toughness

| Coating | Flaking of the edge line (%) after 2 minutes | Flaking of the edge line (%) after 4 minutes |
|---|---|---|
| 1a | 22 | 34 |
| 1b | 18 | 32 |
| 2a | 18 | 41 |

(continued)

| Coating | Flaking of the edge line (%) after 2 minutes | Flaking of the edge line (%) after 4 minutes |
|---|---|---|
| 2b | 12 | 32 |
| 3a | 19 | 29 |
| 3b X | 2 | 8 |
| 3c X | 0 | 4 |
| 4a | 18 | 33 |
| 4b X | 0 | 3 |
| X = invention | | |

Example 3 - Turning Tests

The samples 6, 8, 10 and 12 of Example 1 were tested in carbon steel (C45) without coolant using the following cutting parameters:

Work piece: C45

Insert type: WNMG080412-NM4

Cutting speed: $v_c$=280 m/min

Feed (f) = 0,32 mm/rev

Depth of cut: $a_p$=2,5 mm

Remarks: dry turning

The end of tool life criterion was flank wear > 0.3 mm. Three edges of each variant were tested.

Table 4 - Turning Test results

| Coating | Tool Life (min) |
|---|---|
| 6 | 13.2 |
| 8 | 15.5 |
| 10 X | 21.3 |
| 12 X | 32.2 |
| X = invention | |

**Claims**

1. A cutting tool insert consisting of
a substrate of cemented carbide, cermet, ceramics, steel or a superhard material such as cubic boron nitride (CBN) and a coating with a total thickness of 5 to 40 $\mu$m, the coating consisting of one or more refractory layers of which at least one layer is an $\alpha$-Al$_2$O$_3$ layer having a thickness of 1 to 25 $\mu$m
**characterized in that**
the at least one $\alpha$-Al$_2$O$_3$ layer having a sulphur content of more than 100 ppm analysed by Secondary Ion Mass Spectroscopy (SIMS) and
the at least one $\alpha$-Al$_2$O$_3$ layer having a texture coefficient TC (0 0 12) > 4 for the (0 0 12) growth direction, the TC (0 0 12) being defined as follows:

$$TC(0\,0\,12) = \frac{I(0\,0\,12)}{I_0(0\,0\,12)}\left[\frac{1}{n}\sum_{n=1}^{n}\frac{I(hkl)}{I_0(hkl)}\right]^{-1}$$

(hkl) = measured intensity of the (hkl) reflection
$I_0$ (hkl) = standard intensity of the standard powder diffraction data according to JCPDF-card no. 42-1468
n = number of reflections used in the calculation, whereby the (hkl) reflections used are: (012), (104), (110), (113), (116), (300) and (0 0 12).

2. The cutting tool insert of claim 1 **characterized in that** the at least one $\alpha$-$Al_2O_3$ layer having a sulphur content of more than 120 ppm, preferably more than 150 ppm analysed by SIMS.

3. The cutting tool insert of any of claims 1 or 2 **characterized in that** the coating comprises, in addition to the at least one $\alpha$-$Al_2O_3$ layer, one or more refractory layers consisting of carbide, nitride, carbonitride, oxycarbonitride or borocarbonitride of one or more of Ti, Zr, V and Hf, or combinations thereof deposited using CVD or MT-CVD, having a thickness of from 0.5 to 20 $\mu$m, preferably from 1 to 10 $\mu$m.

4. The cutting tool insert of any of claims 1 to 3 **characterized in that**

a) the uppermost layer of the coating is the $\alpha$-$Al_2O_3$ layer or
b) the uppermost layer of the coating is a layer of carbide, nitride, carbonitride or oxycarbnitride of one or more of Ti, Zr, V and Hf, or combinations thereof, having a thickness of from 0.5 to 3 $\mu$m, preferably 0.5 to 1.5 $\mu$m, being deposited atop of the $\alpha$-$Al_2O_3$ layer or
c) surface areas of the cutting tool insert, preferably the rake face of the cutting tool insert, comprise the $\alpha$-$Al_2O_3$ layer a) as the uppermost layer whereas the remaining surface areas of the cutting tool insert comprise as the uppermost layer a layer b) of carbide, nitride, carbonitride or oxycarbnitride of one or more of Ti, Zr, V and Hf, or combinations thereof, having a thickness of from 0.5 to 3 $\mu$m, preferably 0.5 to 1.5 $\mu$m, being deposited atop of the $\alpha$-$Al_2O_3$ layer.

5. The cutting tool insert of any of claims 1 to 4 **characterized in that** the substrate consists of cemented carbide, preferably of cemented carbide consisting of 4 to 12 wt-% Co, optionally 0.3-10 wt-% cubic carbides of the metals from groups IVb, Vb and VIb of the periodic table, preferably Ti, Nb, Ta or combinations thereof, and balance WC.

6. The cutting tool insert of any of claims 1 to 5 **characterized in that** the substrate consists of cemented carbide comprising a binder phase enriched surface zone having a thickness of 5 to 30 $\mu$m, preferably 10 to 25 $\mu$m, from the substrate surface, the binder phase enriched surface zone having a Co content that is at least 1.5 times higher than in the core of the substrate and having a content of cubic carbides that is less than 0.5 times the content of cubic carbides in the core of the substrate.

7. The cutting tool insert of any of claims 1 to 6 **characterized in that** the at least one $\alpha$-$Al_2O_3$ layer has a texture coefficient TC (0 0 12) > 5, preferably a texture coefficient TC (0 0 12) > 6 for the (0 0 12) growth direction.

8. A method of manufacturing a cutting tool insert of any of the previous claims wherein said at least one $\alpha$-$Al_2O_3$ layer is deposited by chemical vapour deposition (CVD) the reaction gas of the CVD process comprising $H_2$, $CO_2$, $AlCl_3$, HCl and X, with X being $H_2S$, $SO_2$, $SF_6$, or combinations thereof, and optional additions of $N_2$ and Ar, wherein the X is present in the reaction gas mixture in an amount of at least 1.2 vol-% of the total volume of gases in the CVD reaction chamber, the volume ratio of $CO_2$ and X in the CVD reaction chamber lies within the range of $1 \le CO_2/ X \le 7$ during deposition of the at least one $\alpha$-$Al_2O_3$ layer and the volume ratio of $AlCl_3$ / HCl in the CVD reaction chamber is equal or smaller than 1 during deposition of the at least one $\alpha$-$Al_2O_3$ layer.

9. The method of claim 8, wherein the volume proportion of the component X or the combination of components X is present in the reaction gas mixture during deposition of the at least one $\alpha$-$Al_2O_3$ layer in an amount of at least 1.5 vol-% of the total volume of gases in the CVD reaction chamber.

10. The method of any of claims 8 to 9, wherein the volume ratio of $CO_2$ / $AlCl_3$ in the CVD reaction chamber is equal or smaller than 1.5 during deposition of the at least one $\alpha$-$Al_2O_3$ layer.

**11.** The method of any of claims 8 to 10, wherein the CVD process during deposition of the at least one $\alpha$-Al$_2$O$_3$ layer is conducted at a temperature in the range of 850 to 1050 °C, preferably 980 to 1050 °C, most preferably 1000 to 1020 °C and/or the CVD process during deposition of the at least one $\alpha$-Al$_2$O$_3$ layer is conducted at a reaction gas pressure in the range 50 to 120 mbar, preferably 50 to 100 mbar.

**12.** The method of any of claims 8 to 11, wherein the component X in the CVD process is H$_2$S or SO$_2$ or a combination of H$_2$S and SO$_2$, whereby, if the component X in the CVD process is a combination of H$_2$S and SO$_2$, the volume proportion of SO$_2$ does not exceed 20% of the volume amount of H$_2$S.

**13.** The method of any of claims 8 to 12, wherein the reaction gas of the CVD process comprises additions of N$_2$ and/or Ar in a volume amount in the range of 4 to 20 vol%, preferably 10-15 vol%, of the total volume of gases in the CVD reaction chamber.

**Patentansprüche**

**1.** Schneidwerkzeugeinsatz, welcher besteht aus
einem Substrat aus Wolframcarbid, Cermet, Keramik, Stahl oder superhartem Material, wie kubischem Bornitrid (CBN),
und aus einer Beschichtung mit einer Gesamtdicke von 5 bis 40 $\mu$m, wobei die Beschichtung aus einer oder mehreren beständigen Schichten besteht, von denen mindestens eine Schicht eine $\alpha$-Al$_2$O$_3$-Schicht ist, welche eine Dicke von 1 bis 25 $\mu$m aufweist,
**dadurch gekennzeichnet, dass**
die mindestens eine $\alpha$-Al$_2$O$_3$-Schicht einen Schwefelgehalt von mehr als 100 ppm, analysiert durch Sekundärionenmassenspektroskopie (SIMS), aufweist und
die mindestens eine $\alpha$-Al$_2$O$_3$-Schicht einen Texturkoeffizienten TC (0 0 12) > 4 für die (0 0 12)-Wachstumsrichtung aufweist, wobei der TC (0 0 12) wie folgt definiert ist:

$$TC(0\,0\,12) = \frac{I(0\,0\,12)}{I_0(0\,0\,12)}\left[\frac{1}{n}\sum_{n-1}^{n}\frac{I(hkl)}{I_0(hkl)}\right]^{-1}$$

(hkl)= gemessene Intensität der (hkl)-Reflexion
I$_0$(hkl)= Standardintensität der Standardpulverdiffraktionsdaten gemäß JCPDF-Karte Nr. 42-1468
n= Anzahl der Reflexionen, die in der Berechnung verwendet werden, wobei die verwendeten (hkl)-Reflexionen folgende sind: (012), (104), (110), (113), (116), (300) und (0 0 12).

**2.** Schneidwerkzeugeinsatz nach Anspruch 1, **dadurch gekennzeichnet, dass** die mindestens eine $\alpha$-Al$_2$O$_3$-Schicht einen Schwefelgehalt von mehr als 120 ppm, vorzugsweise von mehr als 150 ppm, analysiert durch SIMS, aufweist.

**3.** Schneidwerkzeugeinsatz nach einem der Ansprüche 1 oder 2, **dadurch gekennzeichnet, dass** die Beschichtung zusätzlich zu der mindestens einen $\alpha$-Al$_2$O$_3$-Schicht eine oder mehrere beständige Schichten, bestehend aus Carbid, Nitrid, Carbonitrid, Oxycarbonitrid oder Borcarbonitrid von einem oder mehreren von Ti, Zr, V und Hf oder Kombinationen davon, welche eine Dicke von 0,5 bis 20 $\mu$m, vorzugsweise von 1 bis 10 $\mu$m haben und welche mit Hilfe von CVD oder MT-CVD abgeschieden wurden, aufweist.

**4.** Schneidwerkzeugeinsatz nach einem der Ansprüche 1 bis 3, **dadurch gekennzeichnet, dass**

a) die oberste Schicht der Beschichtung die $\alpha$-Al$_2$O$_3$-Schicht ist, oder
b) die oberste Schicht der Beschichtung eine Schicht aus Carbid, Nitrid, Carbonitrid oder Oxycarbonitrid von einem oder mehreren von Ti, Zr, V und Hf oder Kombinationen davon ist, welche eine Dicke von 0,5 bis 3 $\mu$m, vorzugsweise von 0,5 bis 1,5 $\mu$m, aufweist und welche über der $\alpha$-Al$_2$O$_3$-Schicht abgeschieden wurde, oder
c) Oberflächenbereiche des Schneidwerkzeugeinsatzes, vorzugsweise die Spanfläche des Schneidwerkzeugeinsatzes, die $\alpha$-Al$_2$O$_3$-Schicht a) als oberste Schicht aufweisen, wobei die verbleibenden Oberflächenbereiche des Schneidwerkzeugeinsatzes als oberste Schicht eine Schicht b) aus Carbid, Nitrid, Carbonitrid oder Oxycarbonitrid von einem oder mehreren von Ti, Zr, V und Hf oder Kombinationen davon aufweisen, welche über der $\alpha$-Al$_2$O$_3$-Schicht abgeschieden wurde und welche eine Dicke von 0,5 bis 3 $\mu$m, vorzugsweise von 0,5 bis

1,5 μm, aufweist.

**5.** Schneidwerkzeugeinsatz nach einem der Ansprüche 1 bis 4, **dadurch gekennzeichnet, dass** das Substrat aus Hartmetall, vorzugsweise aus Hartmetall bestehend aus 4 bis 12 Gew.-% Co, optional 0,3-10 Gew.-% kubischen Carbiden von Metallen der Gruppen IVb, Vb und VIb des Periodensystems, vorzugsweise Ti, Nb, Ta oder Kombinationen davon, und Rest-WC besteht.

**6.** Schneidwerkzeugeinsatz nach einem der Ansprüche 1 bis 5, **dadurch gekennzeichnet, dass** das Substrat aus Hartmetall besteht, welches eine mit Binderphase angereicherte Oberflächenzone aufweist, welche eine Dicke von 5 bis 30 μm, vorzugsweise 10 bis 25 μm, von der Substratoberfläche, aufweist, wobei die mit Binderphase angereicherte Oberflächenzone einen Co-Gehalt hat, welcher mindestens 1,5-mal höher ist als im Kern des Substrates, und einen Gehalt an kubischen Carbiden aufweist, welcher weniger als das 0,5-fache des Gehalts der kubischen Carbide im Kern des Substrates ist.

**7.** Schneidwerkzeugeinsatz nach einem der Ansprüche 1 bis 6, **dadurch gekennzeichnet, dass** die mindestens eine $\alpha$-$Al_2O_3$-Schicht einen Texturkoeffizienten TC (0 0 12) >5, vorzugsweise einen Texturkoeffizienten TC (0 0 12) >6 für die (0 0 12)-Wachstumsrichtung aufweist.

**8.** Verfahren zur Herstellung eines Schneidwerkzeugeinsatzes nach einem der vorstehenden Ansprüche, wobei die mindestens eine $\alpha$-$Al_2O_3$-Schicht durch chemische Gasphasenabscheidung (CVD) abgeschieden wird, wobei das Reaktionsgas des CVD-Verfahrens $H_2$, $CO_2$, $AlCl_3$, HCl und X aufweist, wobei X $H_2S$, $SO_2$, $SF_6$ oder Kombinationen davon ist, und optional Zugaben von $N_2$ und Ar, wobei X in dem Reaktionsgasgemisch in einer Menge von mindestens 1,2 Vol.-% des Gesamtvolumens der Gase in der CVD-Reaktionskammer vorliegt, wobei das Volumenverhältnis von $CO_2$ und X in der CVD-Reaktionskammer in dem Bereich von 1≤$CO_2$/X≤7 während der Abscheidung der mindestens einen $\alpha$-$Al_2O_3$-Schicht liegt, und das Volumenverhältnis von $AlCl_3$/HCl in der CVD-Reaktionskammer gleich oder kleiner als 1 während der Abscheidung der mindestens einen $\alpha$-$Al_2O_3$-Schicht ist.

**9.** Verfahren nach Anspruch 8, wobei der Volumenanteil der Komponente X oder der Kombination der Komponenten X während der Abscheidung der mindestens einen $\alpha$-$Al_2O_3$-Schicht in dem Reaktionsgasgemisch in einer Menge von mindestens 1,5 Vol.-% des Gesamtvolumens der Gase in der CVD-Reaktionskammer vorliegt.

**10.** Verfahren nach einem der Ansprüche 8 bis 9, wobei das Volumenverhältnis von $CO_2$/Al-$Cl_3$ in der CVD-Reaktionskammer während der Abscheidung der mindestens einen $\alpha$-$\alpha$-$Al_2O_3$-Schicht gleich oder kleiner als 1,5 ist.

**11.** Verfahren nach einem der Ansprüche 8 bis 10, wobei das CVD-Verfahren während der Abscheidung der mindestens einen $\alpha$-$Al_2O_3$-Schicht bei einer Temperatur im Bereich von 850 bis 1050 °C, vorzugsweise von 980 bis 1050 °C, am meisten bevorzugt 1000 bis 1020 °C durchgeführt wird und/oder das CVD-Verfahren während der Abscheidung der mindestens einen $\alpha$-$Al_2O_3$-Schicht bei einem Reaktionsgasdruck im Bereich von 50 bis 120 mbar, vorzugsweise 50 bis 100 mbar, durchgeführt wird.

**12.** Verfahren nach einem der Ansprüche 8 bis 11, wobei die Komponente X in dem CVD-Verfahren $H_2S$ oder $SO_2$ oder eine Kombination von $H_2S$ und $SO_2$ ist, wobei, wenn die Komponente X in dem CVD-Verfahren eine Kombination von $H_2S$ und $SO_2$ ist, der Volumenanteil von $SO_2$ 20% der Volumenmenge von $H_2S$ nicht übersteigt.

**13.** Verfahren nach einem der Ansprüche 8 bis 12, wobei das Reaktionsgas des CVD-Verfahrens Zusätze von $N_2$ und/oder Ar in einer Volumenmenge im Bereich von 4 bis 20 Vol.-%, vorzugsweise von 10-15 Vol.-%, des Gesamtvolumens der Gase in der CVD-Reaktionskammer aufweist.

**Revendications**

**1.** Plaquette pour outil de découpe constituée de
un substrat de carbure cémenté, de cermet, de céramique, d'acier ou d'un matériau extradur tel que le nitrure de bore cubique (NBC)
et un revêtement ayant une épaisseur totale de 5 à 40 μm, le revêtement étant constitué d'une ou plusieurs couches réfractaires dont au moins une couche est une couche d'a-$Al_2O_3$ ayant une épaisseur de 1 à 25 μm
**caractérisée en ce que**
l'au moins une couche d'$\alpha$-$Al_2O_3$ ayant une teneur en soufre de plus de 100 ppm analysée par spectroscopie de masse des ions secondaires (SIMS) et

l'au moins une couche d'$\alpha$-Al$_2$O$_3$ ayant un coefficient de texture TC (0 0 12) > 4 pour la direction de croissance (0 0 12), le TC (0 0 12) étant défini comme suit:

$$TC(0\,0\,12) = \frac{I(0\,0\,12)}{I_0(0\,0\,12)}\left[\frac{1}{n}\sum_{n-1}^{n}\frac{I(hkl)}{I_0(hkl)}\right]^{-1}$$

(hkl) = intensité mesurée de la réflexion (hkl)

$I_0$ (hkl) = intensité standard des données de diffraction sur poudre standard selon JCPDF - carte n° 42-1468

n = nombre de réflexions utilisées dans le calcul, les réflexions (hkl) utilisées étant: (012), (104), (110), (113), (116), (300) et (0 0 12).

2. Plaquette pour outil de découpe selon la revendication 1 **caractérisée en ce que** l'au moins une couche d'$\alpha$-Al$_2$O$_3$ a une teneur en soufre de plus de 120 ppm, de préférence de plus de 150 ppm analysée par SIMS.

3. Plaquette pour outil de découpe selon l'une quelconque des revendications 1 ou 2 **caractérisée en ce que** le revêtement comprend, outre l'au moins une couche d'$\alpha$-Al$_2$O$_3$, une ou plusieurs couches réfractaires constituées de carbure, de nitrure, de carbonitrure, d'oxycarbonitrure ou de borocarbonitrure d'un ou plusieurs de Ti, Zr, V et Hf, ou de combinaisons de ceux-ci déposées à l'aide de CVD ou de MT-CVD, ayant une épaisseur de 0,5 à 20 $\mu$m, de préférence de 1 à 10 $\mu$m.

4. Plaquette pour outil de découpe selon l'une quelconque des revendications 1 à 3 **caractérisée en ce que**

a) la couche la plus externe du revêtement est la couche d'$\alpha$-Al$_2$O$_3$ ou

b) la couche la plus externe du revêtement est une couche de carbure, de nitrure, de carbonitrure ou d'oxycarbonitrure d'un ou plusieurs de Ti, Zr, V et Hf, ou de combinaisons de ceux-ci, ayant une épaisseur de 0,5 à 3 $\mu$m, de préférence de 0,5 à 1,5 $\mu$m, étant déposées au-dessus de la couche d'$\alpha$-Al$_2$O$_3$ ou

c) les surfaces de la plaquette pour outil de découpe, de préférence la face de coupe de la plaquette pour outil de découpe, comprennent la couche d'$\alpha$-Al$_2$O$_3$ a) en tant que couche la plus externe tandis que les surfaces restantes de la plaquette pour outil de découpe comprennent en tant que couche la plus externe une couche b) de carbure, de nitrure, de carbonitrure ou d'oxycarbonitrure d'un ou plusieurs de Ti, Zr, V et Hf, ou de combinaisons de ceux-ci, ayant une épaisseur de 0,5 à 3 $\mu$m, de préférence de 0,5 à 1,5 $\mu$m, étant déposées au-dessus de la couche d'$\alpha$-Al$_2$O$_3$.

5. Plaquette pour outil de découpe selon l'une quelconque des revendications 1 à 4 **caractérisée en ce que** le substrat est constitué de carbure cémenté, de préférence de carbure cémenté constitué de 4 à 12 % en poids de Co, facultativement de 0,3 à 10 % en poids de carbures cubiques des métaux des groupes IVb, Vb et VIb du tableau périodique, de préférence de Ti, Nb, Ta ou de combinaisons de ceux-ci, et le reste étant représenté par WC.

6. Plaquette pour outil de découpe selon l'une quelconque des revendications 1 à 5 **caractérisée en ce que** le substrat est constitué de carbure cémenté comprenant une zone superficielle enrichie en phase liante ayant une épaisseur de 5 à 30 $\mu$m, de préférence de 10 à 25 $\mu$m, depuis la surface du substrat, la zone superficielle enrichie en phase liante ayant une teneur en Co qui est au moins 1,5 fois plus élevée que dans le coeur du substrat et ayant une teneur en carbures cubiques qui est inférieure à 0,5 fois la teneur en carbures cubiques dans le coeur du substrat.

7. Plaquette pour outil de découpe selon l'une quelconque des revendications 1 à 6 **caractérisée en ce que** l'au moins une couche d'$\alpha$-Al$_2$O$_3$ a un coefficient de texture TC (0 0 12) > 5, de préférence un coefficient de texture TC (0 0 12) > 6 pour la direction de croissance (0 0 12).

8. Procédé de fabrication d'une plaquette pour outil de découpe selon l'une quelconque des revendications précédentes dans lequel ladite au moins une couche d'$\alpha$-Al$_2$O$_3$ est déposée par dépôt chimique en phase vapeur (CVD), le gaz réactionnel du procédé de CVD comprenant de l'H$_2$, du CO$_2$, de l'AlCl$_3$, de l'HCl et du X, X étant de l'H$_2$S, du SO$_2$, du SF$_6$, ou des combinaisons de ceux-ci, et des additions optionnelles de N$_2$ et d'Ar, le X étant présent dans le mélange formant le gaz réactionnel en une quantité d'au moins 1,2 % en vol du volume total de gaz dans la chambre de réaction de CVD, le rapport volumique de CO$_2$ et de X dans la chambre de réaction de CVD se situe dans la plage de $1 \leq CO_2/X \leq 7$ au cours du dépôt de l'au moins une couche d'$\alpha$-Al$_2$O$_3$ et le rapport volumique de AlCl$_3$/HCl

dans la chambre de réaction de CVD est inférieur ou égal à 1 au cours du dépôt de l'au moins une couche d'$\alpha$-$Al_2O_3$.

9. Procédé selon la revendication 8, dans lequel la proportion en volume du composant X ou de la combinaison de composants X est présente dans le mélange formant le gaz réactionnel au cours du dépôt de l'au moins une couche d'$\alpha$-$Al_2O_3$ en une quantité d'au moins 1,5 % en vol du volume total de gaz dans la chambre de réaction de CVD.

10. Procédé selon l'une quelconque des revendications 8 à 9, dans lequel le rapport volumique de $CO_2$/$AlCl_3$ dans la chambre de réaction de CVD est inférieur ou égal à 1,5 au cours du dépôt de l'au moins une couche d'$\alpha$-$Al_2O_3$.

11. Procédé selon l'une quelconque des revendications 8 à 10, dans lequel le procédé de CVD au cours du dépôt de l'au moins une couche d'$\alpha$-$Al_2O_3$ est réalisé à une température dans la plage de 850 à 1050 °C, de préférence de 980 à 1050 °C, de manière préférée entre toutes de 1000 à 1020 °C et/ou le procédé de CVD au cours du dépôt de l'au moins une couche d'$\alpha$-$Al_2O_3$ est réalisé à une pression de gaz réactionnel dans la plage de 50 à 120 mbar, de préférence de 50 à 100 mbar.

12. Procédé selon l'une quelconque des revendications 8 à 11, dans lequel le composant X dans le procédé de CVD est de l'$H_2S$ ou du $SO_2$ ou une combinaison d'$H_2S$ et de $SO_2$, moyennant quoi, si le composant X dans le procédé de CVD est une combinaison d'$H_2S$ et de $SO_2$, la proportion en volume de $SO_2$ ne dépasse pas 20 % de la quantité volumique d'$H_2S$.

13. Procédé selon l'une quelconque des revendications 8 à 12, dans lequel le gaz réactionnel du procédé de CVD comprend des additions de $N_2$ et/ou d'Ar en une quantité volumique dans la plage de 4 à 20 % en vol, de préférence de 10 à 15 % en vol, du volume total de gaz dans la chambre de réaction de CVD.

**EP 2 570 510 B2**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4619866 A
- EP 0045291 A
- EP 1788124 A
- EP 1683893 A